# EUROPEAN PATENT APPLICATION

(11) **EP 4 844 425 A1**
(43) Date of publication of application: **25.11.2026**
(21) Application number: 26172584.0
(22) Date of filing: 15.04.2026
(51) Int. Cl.: G01R 31/327

(54) **DETECTION CIRCUIT AND DETECTION METHOD OF THE SAME**

(30) Priority: 13.05.2025 CN 202510611494
(71) Applicant: DELTA ELECTRONICS, INC., Taoyuan City 320023 (TW)
(72) Inventor: LIAO, BO-JYUN, 320023 Chungli Dist., Taoyuan City (TW); SHIH, I-Hsiang, 320023 Taoyuan City (TW); HUANG, Chun-Hao, 320023 Taoyuan City (TW)
(74) Representative: 2K Patent Partnerschaft mbB

(57) **Abstract**

A detection circuit (6) is used for detecting whether a plurality of relays (RL, RL1, RL2, RL3, RLP, RLN) of a switch circuit (1) are normally actuated in sequence, and the switch circuit (1) is coupled between a power end (3) for receiving an AC voltage (Vac) and an input end (4) of a conversion circuit (2). The detection circuit (6) is used for detecting the power end (3) to provide a first voltage parameter, and for detecting the input end (4) to provide a second voltage parameter. When an initial relay is turned on, the detection circuit (6) determines whether a sticking fault has occurred in the switch circuit (1) according to a first RMS value in the first voltage parameter and a second RMS value in the second voltage parameter. When a final relay is turned on, the detection circuit (6) determines whether a bridging fault has occurred in the switch circuit (1) according to a first instantaneous value and a second instantaneous value.

## Description

### BACKGROUND

### Technical Field

The present disclosure relates to detection circuit and detection method of the same, and more particularly to a hybrid detection circuit and detection method of the same for a switch circuit at an input end of a conversion circuit.

### Description of Related Art

In electric vehicle charging or power conversion circuits, where the input end is a high voltage source such as medium voltage alternating current (MVAC), it is usually necessary to use relay(s) in a switch circuit to isolate the voltage source of the input end and the power source of the converter. Moreover, when the converter needs to be enabled to operate, the relays need to be bridged sequentially, so that the large power input source is not supplied to the converter all at once, so as to avoid the converter being unable to withstand and being damaged.

However, under the condition that the contacts of the relay are corroded or carbonized, or the electromagnetic coils are aged or connected to a short circuit, the relay may stick or fail to bridge successfully. When these conditions occur, there is still a condition where the power supply to the converter is too large for a short period of time, so that the converter is still at risk of being damaged. Therefore, the customary solution to the above defects of the relay is to detect the voltage at the two ends of the switch circuit to confirm whether the relay is actuated correctly. However, under the condition of real relay failure, the part of the voltage source may have been supplied to the converter. Therefore, if only a single detection method is used, the accuracy of switch circuit detection may be low because part of the energy of the voltage source is present at the input end. Therefore, it may lead to an error in determining whether the relay is normal, resulting in a more serious fault condition.

Therefore, how to design a detection circuit and a detection method of the same to improve the detection accuracy of the switch circuit has become a critical topic in this field.

### SUMMARY

In order to solve the problems above, the present disclosure provides a detection method to overcome the issues of the prior art. Therefore, the detection method of the present disclosure is used for detecting whether a plurality of relays of a switch circuit are operating normally, and the switch circuit is coupled between a power end for receiving an AC voltage and an input end of a conversion circuit, so that the AC voltage is configured to supply power to the conversion circuit through the switch circuit. The detection method comprising steps of: sequentially controlling the relays to operate when the conversion circuit is intended to receive the AC voltage; determining whether at least one of the relays has been normally turned on according to a first RMS value of the AC voltage at the power end and a second RMS value at the input end, when controlling an initial relay of the relays to be turned on; determining that a sticking fault has occurred in the switch circuit, when a first difference value between the first RMS value and the second RMS value is lower than a first voltage threshold; determining whether a final relay has been normally turned on according to a first instantaneous value of the AC voltage at the power end and a second instantaneous value at the input end, when controlling the final relay of the relays to be turned on; determining that a bridging fault has occurred in the switch circuit, when a second difference value between the first instantaneous value and the second instantaneous value is higher than a second voltage threshold.

In order to solve the problems above, the present disclosure provides a detection circuit to overcome the issues of the prior art. Therefore, the detection circuit of the present disclosure is used for detecting whether a plurality of relays of a switch circuit are operating normally, and the switch circuit is coupled between a power end for receiving an AC voltage and an input end of a conversion circuit, so that the AC voltage is configured to supply power to the conversion circuit through the switch circuit. The detection circuit includes a first detection circuit, a second detection circuit and a controller. The first detection circuit is coupled to the power end and is configured to detect the AC voltage and provide a first voltage parameter. The second detection circuit is coupled to the input end and is configured to detect the AC voltage at the input end and provide a second voltage parameter. The controller is coupled to the first detection circuit, the second detection circuit, and the relays, and wherein the relays are sequentially operated when the conversion circuit is intended to receive the AC voltage. Wherein when an initial relay of the relays is turned on, the controller is configured to determine whether a sticking fault has occurred in the switch circuit according to a first RMS value of the first voltage parameter and a second RMS value of the second voltage parameter; when a final relay of the relays is turned on, the controller is configured to determine whether a bridging fault has occurred in the switch circuit according to a first instantaneous value of the first voltage parameter and a second instantaneous value of the second voltage parameter.

The main purpose and effect of the present disclosure is that the switch circuit detection method of the present disclosure is a hybrid application of the two detection methods that the RMS value with the instantaneous value, so as to reduce the probability of erroneous determination by using the other determination method when one of the two has a higher risk of the erroneous determination, so as to achieve the effect of improving the accuracy of the detection of the switch circuit.

It is to be understood that both the foregoing general description and the following detailed description are exemplary, and are intended to provide further explanation of the present disclosure as claimed. Other advantages and features of the present disclosure will be apparent from the following description, drawings, and claims.

### BRIEF DESCRIPTION OF DRAWINGS

The present disclosure can be more fully understood by reading the following detailed description of the embodiment, with reference made to the accompanying drawing as follows:
FIG. 1 is a circuit block diagram of an AC/DC conversion circuit according to the present disclosure.
FIG. 2A is a waveform schematic diagram of a first detection method of the detection circuit according to the present disclosure.
FIG. 2B is a waveform schematic diagram of a second detection method of the detection circuit according to the present disclosure.
FIG. 2C is a waveform diagram of possible conditions that may occur when a relay operation according to the present disclosure.
FIG. 3A is a circuit block diagram of a first embodiment of the AC/DC conversion circuit according to the present disclosure.
FIG. 3B is a relay control timing diagram of the first embodiment according to the present disclosure.
FIG. 4A is a circuit block diagram of a second embodiment of the AC/DC conversion circuit according to the present disclosure.
FIG. 4B is a relay control timing diagram of the second embodiment according to the present disclosure.

### DETAILED DESCRIPTION

Reference will now be made to the drawing figures to describe the present disclosure in detail. It will be understood that the drawing figures and exemplified embodiments of present disclosure are not limited to the details thereof.

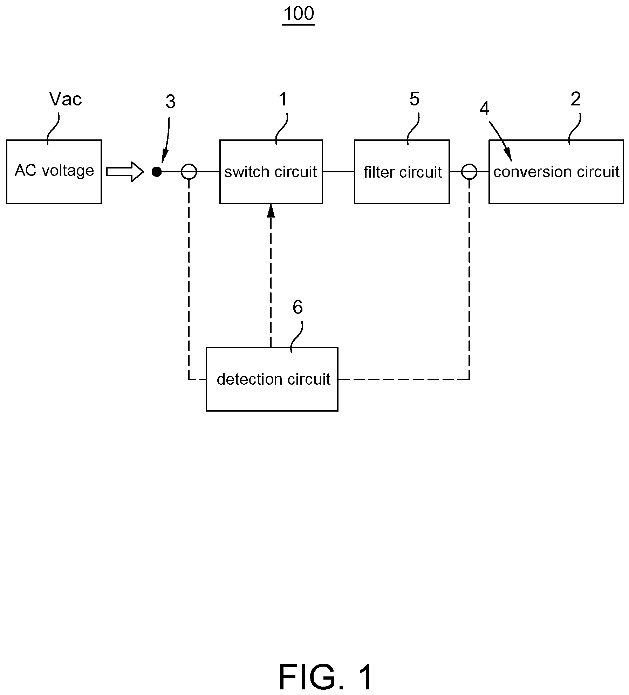

Please refer to FIG. 1, which shows a circuit block diagram of an AC/DC conversion circuit according to the present disclosure. The AC/DC conversion circuit 100 includes a switch circuit 1 and a conversion circuit 2, and the AC/DC conversion circuit 100 is used to provide an AC voltage Vac to the conversion circuit 2, so that the conversion circuit 2 may convert the AC voltage Vac to a DC voltage to supply power to a load (not shown in the FIG. 1). The switch circuit 1 is coupled between a power end 3 for receiving the AC voltage Vac and an input end 4 of the conversion circuit 2. When the AC voltage Vac has not yet been supplied to the conversion circuit 2, the AC/DC conversion circuit 100 controls the switch circuit 1 not to operate, so that the power end 3 and the input end 4 are disconnected, and the conversion circuit 2 cannot perform AC-DC conversion. Conversely, when the conversion circuit 2 is intended to receive the AC voltage Vac and operate, the AC/DC conversion circuit 100 controls the switch circuit 1 to actuate, so that the power end 3 and the input end 4 are connected, and the input end 4 are disconnected, and the conversion circuit 2 may convert the AC voltage Vac to the DC voltage.

Referring again to FIG. 1, the AC/DC conversion circuit 100 also includes a filter circuit 5 and a detection circuit 6. The filter circuit 5 may be coupled between the switch circuit 1 and the conversion circuit 2, and when the AC voltage Vac flows through the filter circuit 5, the filter circuit 5 may filter the AC voltage Vac to eliminate noise and electromagnetic interference of the AC voltage Vac. The detection circuit 6 is used to control the actuation of the switch circuit 1 and to detect voltage parameters of two ends of the switch circuit 1 to determine whether the switch circuit 1 is acting normally. Specifically, the detection circuit 6 is coupled to the power end 3 and is used to detect the AC voltage Vac of the power end 3 to acquire a first voltage parameter. Furthermore, the detection circuit 6 is also coupled to the input end 4 and is used to detect a voltage of the input end 4 to acquire a second voltage parameter. Therefore, after detecting the actuation of the switch circuit 1, the detection circuit 6 may determine whether the switch circuit 1 is actuated normally according to the first voltage parameter and the second voltage parameter.

Further, the switch circuit 1 includes a plurality of relays, and the detection circuit 6 performs relay diagnosis by acquiring voltage parameters of the front and rear ends of the relays, so as to determine whether a sticking fault or a bridging fault has occurred has occurred through the voltage parameters of the front and rear ends of the relays. In one embodiment, the detailed circuit structure and detection circuit of the AC/DC conversion circuit 100 will be further described later, and will not be repeated herein. In addition, in another embodiment, the conversion circuit 2 may be a power factor corrector with a power factor correction function, and the AC/DC conversion circuit 100 may be applied to a power system, preferably an on-board charger (OBC) in an electric vehicle charging system, but not limited thereto.

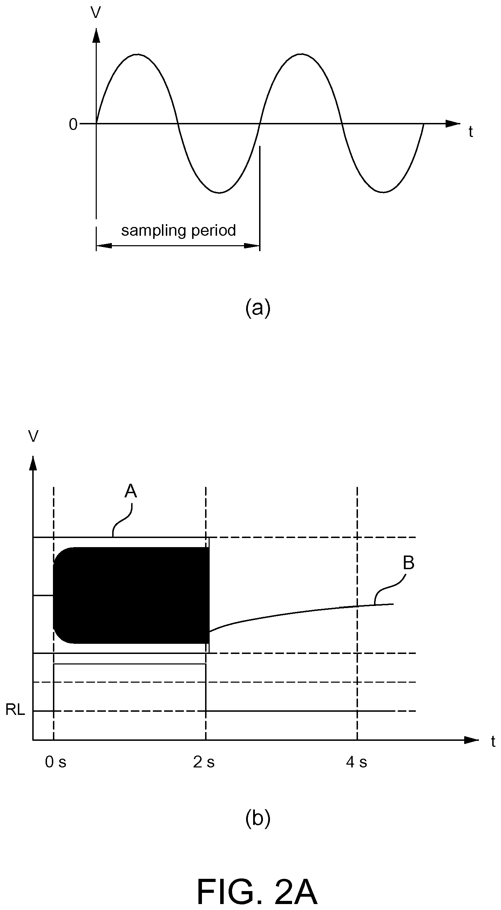

Please refer to FIG. 2A, which shows a waveform schematic diagram of a first detection method of the detection circuit according to the present disclosure, and also refer to FIG. 1. The first detection method of the detection circuit 6 of the present disclosure detects whether the relay RL is actuated normally by using a root-mean-square (RMS) value of the AC voltage Vac. Specifically, with reference to small diagram (a) of FIG. 2A, the detection circuit 6 may detect the AC voltage Vac at the power end 3 and the voltage at the input end 4 to acquire the first voltage parameter and the second voltage parameter respectively. Then, the detection circuit 6 uses the first voltage parameter and the second voltage parameter to acquire the first RMS value of the AC voltage Vac at the power end 3 and the second RMS value of the voltage at the input end 4 respectively (i.e., the voltage RMS value (Vrms) of the two ends). In particular, the sampling period of the detection circuit 6 for the RMS value may be a cycle of an AC sine wave, but is not limited thereto.

Moreover, the detection circuit 6 may subtract the first RMS value of the power end 3 with the second RMS value of the input end 4 to acquire the first difference value (i.e., the difference between the two RMS values). Therefore, the detection circuit 6 may determine whether the relay RL is acting normally by the first difference value. When the detection circuit 6 controls the relay RL to be turned off (i.e., the relay RL should not be bridged yet or the bridged relay RL should be disconnected) and the first difference value is lower than the first voltage threshold preset by the detection circuit 6, the detection circuit 6 may determine that the relay RL is sticking and a sticking fault has occurred. Conversely, when the detection circuit 6 controls the relay RL to be turned on (i.e., the relay RL should be bridged) and the first difference value is higher than the first voltage threshold preset by the detection circuit 6, the detection circuit 6 may determine that the relay RL is un-bridged (i.e., the relay RL does not bridge successfully) and a bridging fault has occurred. In one embodiment, the terms "lower" and "higher" as described in the present disclosure are relative terms. For example, but not limited to, "lower than" may be expressed as "less than" or "less than or equal to", and the corresponding "higher than" may be expressed as "greater than or equal to" or "greater than", even "equal to" may be used to make further determinations (e.g., delayed for a period of time, etc.), so there is not limited thereto.

However, the use of the rms value of AC voltage Vac to determine whether the relay RL is actuated normally may be defective under specific conditions. Specifically, with reference to small diagram (b) of FIG. 2A, the waveform A is the voltage waveform of power end 3 and the waveform B is the voltage waveform of input end 4. Since the filter circuit 5 between the switch circuit 1 and the conversion circuit 2 may include an X capacitor, the voltage energy on the X capacitor will not dissipate immediately after the relay RL is turned off (i.e., time 2s) and a capacitive discharging waveform appears, resulting in a voltage value still being present at the input end 4 (as shown in the waveform B at times 2s to 4s). Therefore, under this condition, the detection circuit 6 using only the RMS value detection method may cause an erroneous determination of the relay RL actuating fault, especially when the X capacitor is not discharged immediately, which is more likely to cause the detection circuit 6 to make the erroneous determination.

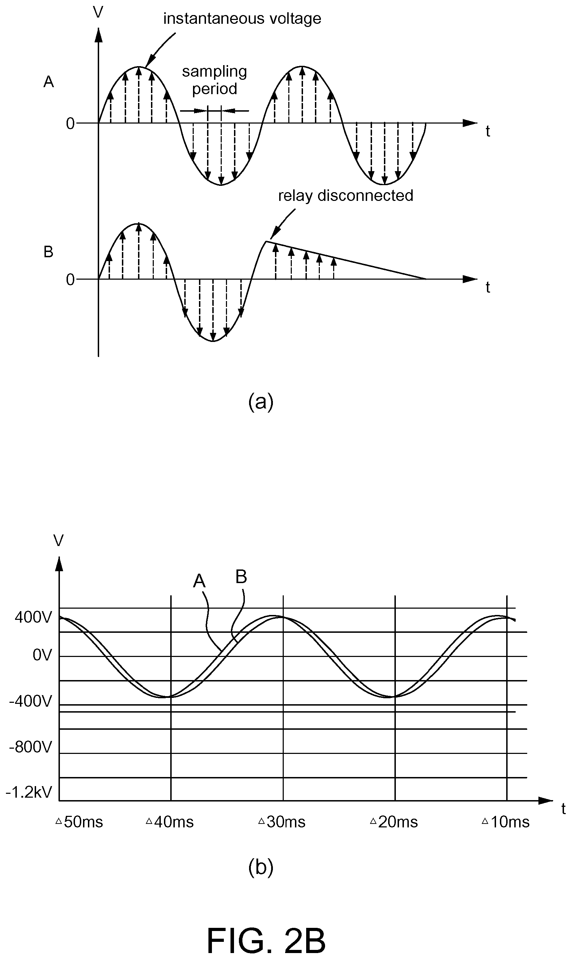

Please refer to FIG. 2B, which shows a waveform schematic diagram of a second detection method of the detection circuit according to the present disclosure, and also refer to FIGs. 1 to 2A. The first detection method of the detection circuit 6 of the present disclosure detects whether the relay RL is actuated normally by using an instantaneous value of the AC voltage Vac. Specifically, with reference to small diagram (a) of FIG. 2B, the detection circuit 6 may determine whether the relay RL is actuating normally according to an instantaneous voltage recorded in the first voltage parameter and the second voltage parameter, and the detection circuit 6 may acquire the instantaneous voltage of the power end 3 and the input end 4 using a fixed sampling cycle, but is not limited thereto.

Then, the detection circuit 6 may subtract the first instantaneous value of the power end 3 with the second instantaneous value of the input end 4 to acquire the second difference value (that is, the difference value between the instantaneous voltages of the power end 3 and the input end 4 at the same point in time). Therefore, the detection circuit 6 may determine whether the relay RL is acting normally by the second difference value. When the detection circuit 6 controls the relay RL to turn off (i.e., the relay RL should not be bridged yet or the bridged relay RL should be disconnected) and the second voltage threshold is lower than the second voltage threshold preset by the detection circuit 6, the detection circuit 6 may determine that the relay RL is sticking and a sticking fault has occurred. Conversely, when the detection circuit 6 controls the relay RL to be turned on (i.e., the relay RL should be bridged) and the second difference value is higher than the second voltage threshold preset by the detection circuit 6, the detection circuit 6 may determine that the relay RL is un-bridged (i.e., the relay RL does not bridge successfully) and a bridging fault has occurred.

Therefore, the instantaneous value may also detect whether the relay RL is faulty, and there is no erroneous determination of whether the relay RL is actuating faults due to residual voltage energy of the X capacitor during the detecting process as shown in Fig. 2A. However, with reference to small diagram (b) of FIG. 2B, the waveform A is also the voltage waveform of power end 3 and the waveform B is also the voltage waveform of input end 4. Under the condition that an impedance loop is bridged by the relay RL (for example, but not limited to, the resistor R on the pre-charge loop), the voltage between the power end 3 and the input end 4 will have a phase difference due to the impedance of the resistor R and the capacitor element, and the magnitude of the phase difference is changed according to the change of the resistance and capacitance values. Therefore, under this condition, the detection circuit 6 using only the instantaneous value detection method may also cause an erroneous determination of the relay RL actuating fault, especially when the phase difference is large, which is more likely to cause the detection circuit 6 to make the erroneous determination.

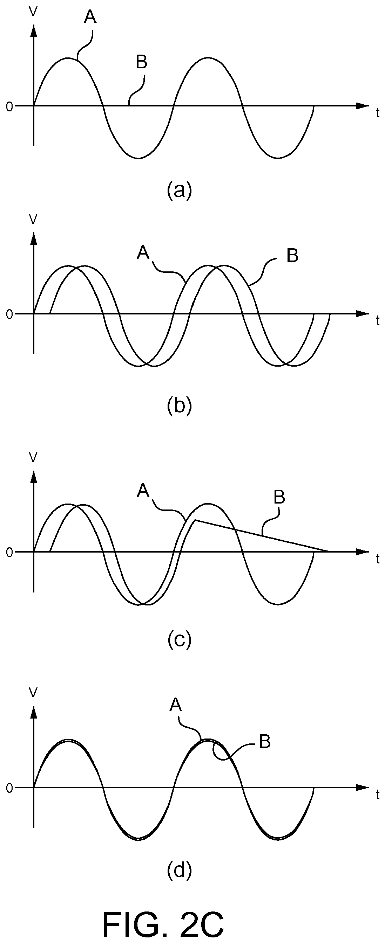

Please refer to FIG. 2A, which shows a waveform diagram of possible conditions that may occur when a relay operation according to the present disclosure, and also refer to FIGs. 1 to 2B. Since the detection circuit 6 has a specific accuracy rate for both the RMS value detection method and the instantaneous value detection method, there is a risk of the erroneous determination under different conditions. Therefore, in order to cope with the various bridging conditions such as FIGs. 2A and 2B and to improve the diagnostic reliability, the detection method of the switch circuit of the present disclosure is a hybrid application of the two detection methods in FIGs. 2A and 2B. Therefore, the probability of erroneous determination is reduced by using the other determination method when one of the two has a higher risk of the erroneous determination, so as to achieve the effect of improving the accuracy of the detection of the switch circuit. Further, FIG. 2C summarizes the various bridging conditions and internal and external voltage changes, and compares the reliability of the two detecting methods in FIGs. 2A and 2B.

Referring to small diagram (a) of FIG. 2C, which shows the waveform that when the detection circuit 6 controls the relay RL to turn on (i.e., the relay RL should be bridged) but the relay RL is actually still turned off. Since the detection circuit 6 controls the relay RL to turn on, but the relay RL is actually still turned off, waveform A (voltage waveform at power end 3) is a sine wave of AC voltage Vac, and waveform B (voltage waveform at input end 4) is not detected due to the relay RL being turned off. Since waveform B does not show the condition of X capacitor discharge shown in the small diagram (b) of FIG. 2A, nor does it show the condition of phase difference between waveform A and waveform B shown in the small diagram (b) of F IG. 2B, the small diagram (a) of FIG. 2C may use the RMS value detection with determination method shown in FIG. 2A, or the instantaneous value detection with determination method shown in FIG. 2B.

Referring to small diagram (b) of FIG. 2C, which shows the waveform that when the detection circuit 6 controls the relay RL to turn off (i.e., the relay RL should not be bridged yet or the bridged relay RL should be disconnected) but the relay RL is actually still turned on under the condition that there is an impedance loop on the path of the relay RL. Since the detection circuit 6 controls the relay RL to turn off, but the relay RL is actually still turned on, waveform A (voltage waveform at power end 3) is a sine wave of AC voltage Vac, and waveform B (voltage waveform at input end 4) is a sine wave of AC voltage Vac because the relay RL is still turned on. Therefore, a bridging fault occurs in relay RL, and there is a phase difference between waveform A and waveform B due to the impedance loop. Since waveform B has the phase difference between waveform A and waveform B as shown in the small diagram (b) of FIG. 2B, the RMS value detection with determination method shown in FIG. 2A may be used for the small diagram (b) of FIG. 2C, but the instantaneous value detection with determination method shown in FIG. 2B is not suitable.

Referring to small diagram (c) of FIG. 2C, which shows the waveform that when the detection circuit 6 controls the relay RL to turn off (i.e., the relay RL should not be bridged yet or the bridged relay RL should be disconnected) and the relay RL may turn off normally under the condition that the filter circuit 5 between the switch circuit 1 and the conversion circuit 2 includes an X capacitor. Since the detection circuit 6 controls the relay RL to turn off and the relay RL actually turns off normally, the waveform A (voltage waveform at the power end 3) is a sine wave of AC voltage Vac, and the waveform B (voltage waveform at the input end 4) is the capacitive discharging waveform after the relay RL turns off due to the discharge of the X capacitor. Since waveform B has the capacitive discharging condition shown in the small diagram (b) of FIG. 2A, the instantaneous value detection with determination method shown in FIG. 2B may be used for the small diagram (c) of FIG. 2C, but the RMS value detection with determination method shown in FIG. 2A is not suitable.

Referring to small diagram (d) of FIG. 2C, which shows the waveform that when the detection circuit 6 controls the relay RL to turn off (i.e., the relay RL should not be bridged yet or the bridged relay RL should be disconnected) but the relay RL is actually still turned on, or when the detection circuit 6 controls the relay RL to turn on (i.e., the relay RL should be bridged) and the relay RL may turn off normally. Under the condition that when the detection circuit 6 controls the relay RL to turn off (i.e., the relay RL should not be bridged yet or the bridged relay RL should be disconnected) but the relay RL is actually still turned on, since the detection circuit 6 controls relay RL to turn off but relay RL is actually still turned on, waveform A (voltage waveform at power end 3) is a sine wave of AC voltage Vac, and waveform B (voltage waveform at input end 4) is a sine wave of AC voltage Vac due to the relay RL being turned on. Therefore, the relay RL has occurred a sticking failure. Since waveform B does not show the condition of X capacitor discharge shown in the small diagram (b) of FIG. 2A, nor does it show the condition of phase difference between waveform A and waveform B shown in the small diagram (b) of FIG. 2B, the small diagram (a) of FIG. 2C may use the RMS value detection with determination method shown in FIG. 2A, or the instantaneous value detection with determination method shown in FIG. 2B.

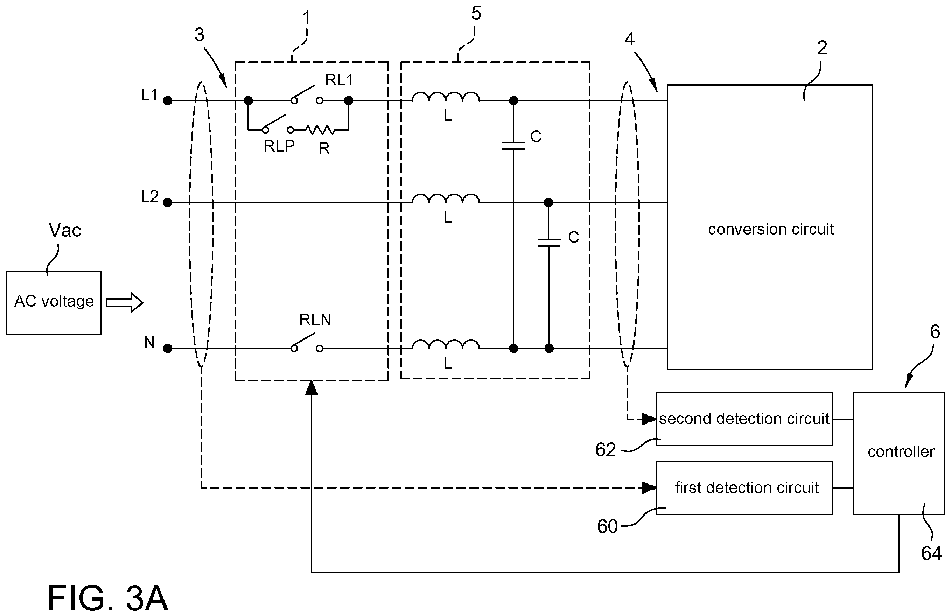

Please refer to FIG. 3A, which shows a circuit block diagram of a first embodiment of the AC/DC conversion circuit according to the present disclosure, and also refer to FIGs. 1 to 2C. In FIG. 3A, the AC/DC conversion circuit 100 includes the switch circuit 1, the conversion circuit 2, the filter circuit 5, and the detection circuit 6. The conversion circuit 2 is a single-phase input circuit (single-phase three-wire input) and includes a first phase path L1, a second phase path L2, and a neutral path N. The switch circuit 1 includes a first relay RL1, a neutral line relay RLN, and a pre-charge relay RLP, and the first relay RL1 is connected in series with the first phase path L1. The pre-charge relay RLP is connected in series with a resistor R to form a pre-charge loop (i.e., an impedance loop), and the pre-charge loop is connected in parallel with the first relay RL1. Since the input capacitance of the conversion circuit 2 is equivalent to a short circuit due to no power supply during the transient state when the AC voltage Vac is supplied power to the conversion circuit 2, the pre-charge loop mainly turns on the pre-charge loop first to suppress the current through resistor R during the transient state when the AC voltage Vac is supplied power to the conversion circuit 2, thereby preventing excessive current from flowing to the conversion circuit 2 and causing an overcurrent condition.

The filter circuit 5 may be coupled between the switch circuit 1 and the conversion circuit 2, and includes a plurality of filter inductors L and a plurality of filter capacitors C. The filter inductors L are connected in series with each path of the single-phase input circuit, and the filter capacitors C act as X capacitors to eliminate noise and electromagnetic interference from the AC voltage Vac. The detection circuit 6 includes a first detection circuit 60, a second detection circuit 62, and a controller 64, and the first detection circuit 60 and the second detection circuit 62 are coupled to the power end 3 and the input end 4 respectively. Specifically, the first detection circuit 60 is coupled to each path (i.e., the first phase path L1, the second phase path L2, and the neutral path N) of the power end 3, and detects the voltage (i.e., the AC voltage Vac) on each path of the power end 3 to provide the first voltage parameter. The second detection circuit 62 is coupled to each path (i.e., the first phase path L1, the second phase path L2, and the neutral path N) of the input end 4 and detects the voltage on each path of the input end 4 to provide the second voltage parameter.

The controller 64 is coupled to the first detection circuit 60, the second detection circuit 62, and each relay (i.e., the first relay RL1, the neutral line relay RLN, and the pre-charge relay RLP) of the switch circuit 1, and when the conversion circuit 2 is to be enabled by receiving the AC voltage Vac, the controller 64 controls the relays (i.e., the first relay RL1, the neutral line relay RLN, and the pre-charge relay RLP) in the switch circuit 1 to actuate in sequence. Furthermore, the controller 64 determines whether the relays of the switch circuit 1 are actuated normally by acquiring the first voltage parameter provided by the first detection circuit 60 and the second voltage parameter provided by the second detection circuit 62.

In one embodiment, the controller 64 may be a single controller chip or comprise multiple control modules. For example, but not limited to, the controller 64 respectively comprises a control module for controlling the conversion circuit 2, a control module (not shown) for controlling the actuation of the switch circuit 1, and a control module (not shown) for monitoring the switch circuit 1 by the first voltage parameter and the second voltage parameter. The controller 64 may even include only a control module (not shown) for monitoring the switch circuit 1 (for example, but not limited to, a signal processing device such as a computer). Therefore, the present disclosure does not limit the types of controllers 64 (for example, but not limited to, computers, controller chips, remote monitoring devices, etc.) and the range of the AC/DC conversion circuits 100 that may be controlled (for example, but not limited to being used only for monitoring, or being able to control the operation of the entire AC/DC conversion circuit 100). However, in order to avoid obscuring the main features of the present disclosure, the controller 64 of the present disclosure is illustrated as being able to control the entire AC/DC conversion circuit 100, but is not limited thereto.

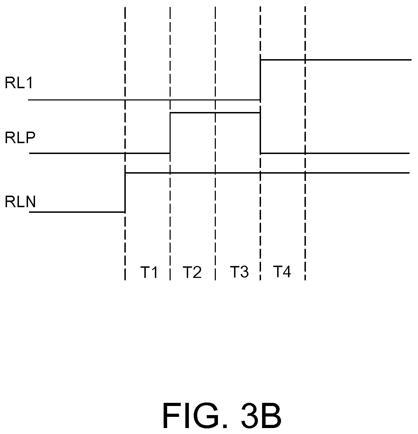

Please refer to FIG. 3B, which shows a relay control timing diagram of the first embodiment according to the present disclosure, and also refer to FIGs. 1 to 3A. In FIG. 3B mainly shows the timing of the relays (i.e., the first relay RL1, the neutral line relay RLN, and the pre-charge relay RLP) of FIG. 3A when the conversion circuit 2 is intended to receive the AC voltage Vac to enable, and the detection circuits used in each time period T1 to T4 will be described sequentially. In FIG. 3B, the controller 64 sequentially controls the neutral line relay RLN, the pre-charge relay RLP, and the first relay RL1 to be turned on, and when the first relay RL1 is turned on, the pre-charge relay RLP that is connected in parallel with the first relay RL1 is turned off to avoid the resistor R from continuously wasting power. Therefore, the controller 64 sets the neutral line relay RLN as an initial relay (i.e., the first relay to be controlled for turning on) and sets the first relay RL1 as the final relay (i.e., the last relay to be controlled for turning on).

Before the time period T1, the conversion circuit 2 is intended to receive the AC voltage Vac and be enabled. Therefore, during the time period T1, the controller 64 controls the neutral line relay RLN that is set as the initial relay to turn on. Furthermore, when the controller 64 controls the neutral line relay RLN to turn on, the controller 64 acquires the first RMS value on the first phase path L1 of the power end 3 by the first voltage parameter and the second RMS value on the first phase path L1 of the input end 4 by the second voltage parameter. Then, the controller 64 presets the first voltage threshold value, and when the first difference value between the first RMS value and the second RMS value is lower than the first voltage threshold value, the controller 64 determines that the first relay RL1 or the pre-charge relay RLP is sticking and the sticking fault has occurred.

Further, when the controller 64 controls the neutral line relay RLN to turn on, and regardless of whether the neutral line relay RLN turns on normally, the conversion circuit 2 should not yet form a complete input loop. Therefore, the waveform between the power end 3 and the input end 4 should be as in small diagram (a) of FIG. 2C. However, if the neutral line relay RLN is turned on normally and the first relay RL1 or pre-charge relay RLP is stuck and still in turn on state, the conversion circuit 2 may form the complete input loop. Therefore, the waveform as shown in small diagram (b) or (d) of FIG. 2A is generated between the power end 3 and the input end 4. So that, regardless of whether it is the small diagram (b) or (d) of FIG. 2A, using the RMS value detection method has higher accuracy. Therefore, by comparing the first difference value between the first RMS value and the second RMS value with the first voltage threshold, it is possible to correctly determine whether the first relay RL1 or the pre-charge relay RLP is stuck. In addition, since the impedance loop is formed when the pre-charge relay RLP sticks, the controller 64 may confirm whether the first relay RL1 or the pre-charge relay RLP is stuck by determining the phase difference. Specifically, the controller 64 presets a phase threshold value, and when the controller 64 determines that the phase difference between the first RMS value and the second RMS value is lower than the phase threshold value, it means that the impedance loop has not been formed. Therefore, the controller 64 determines that the first relay RL1 is stuck and the sticking fault has occurred. Conversely, when the controller 64 determines that the phase difference between the first RMS value and the second RMS value is higher than the phase threshold value, it means that the impedance loop has been formed. Therefore, the controller 64 determines that the pre-charge relay RLP is stuck and the sticking fault has occurred. In one embodiment, when a relay in switch circuit 1 is turned on normally, controller 64 should stop subsequent operations and issue a warning. Subsequent operations may include, but are not limited to, attempting to turn off all relays, and will not be repeated herein.

At time period T2, the neutral line relay RLN should be turned on normally, and controller 64 controls pre-charge relay RLP to turn on. Furthermore, when the controller 64 controls the pre-charge relay RLP to turn on, the controller 64 acquires the first RMS value on the first phase path L1 of the power end 3 through the first voltage parameter, and acquires the second RMS value on the first phase path L1 of the input end 4 through the second voltage parameter. when the first difference value between the first RMS value and the second RMS value is higher than the first voltage threshold, the controller 64 determines that the pre-charge relay RLP or the neutral line relay RLN is un-bridged and the bridging fault has occurred.

Furthermore, when the controller 64 controls the pre-charge relay RLP to turn on, and both the pre-charge relay RLP and the neutral line relay RLN must be turned on normally, the conversion circuit 2 will form a complete input loop. Therefore, the waveform between the power end 3 and the input end 4 should be as shown in the small diagram (b) in FIG. 2C, and there should be the phase difference between waveform A and waveform B. However, if one of the pre-charge relay RLP and the neutral line relay RLN cannot be bridged successfully, the conversion circuit 2 cannot form a complete input loop. Therefore, the waveform shown in the small diagram (a) in FIG. 2A is generated between the power end 3 and the input end 4. Under the present conditions, since the input loop should include an impedance loop, which involves the waveform with the phase difference, using the RMS value detection method has higher accuracy. In one embodiment, the controller 64 may selectively provide a time period T3 for temporarily delaying the next actuation, so as to provide the pre-charge loop through the time period T3 to charge the capacitor at the input end of the conversion circuit 2 to a specific value, thereby avoiding a condition that an excessive current flowing to the conversion circuit 2.

At the time period T4, the neutral line relay RLN and pre-charge relay RLP should be turned on normally, and the controller 64 controls the first relay RL1 that is set as the final relay to turn on. Furthermore, when the controller 64 controls the first relay RL1 to turn on, the controller 64 also controls the pre-charge relay RLP to turn off, so that the main power path may be adjusted from the pre-charge loop to the main loop to avoid the resistor R continuously consuming power and causing the AC/DC conversion circuit 100 to be inefficient. Then, the controller 64 acquires the first instantaneous value on the first phase path L1 of the power end 3 through the first voltage parameter, and acquires the second instantaneous value on the first phase path L1 of the input end 4 through the second voltage parameter. Finally, the controller 64 presets the second voltage threshold, and when the second difference value between the first instantaneous value and the second instantaneous value is higher than the second voltage threshold, the controller 64 determines that the first relay RL1 is un-bridged and the bridging fault has occurred.

Furthermore, when the controller 64 controls the first relay RL1 to turn on and the pre-charge relay RLP is turned off, the conversion circuit 2 should still have the complete input loop, and no impedance loop is formed in the input loop. Therefore, the waveform between the power end 3 and the input end 4 should be as shown in the small diagram (d) in FIG. 2C. However, if the first relay RL1 cannot be bridged successfully, the input loop is disconnected and there is energy on the filter capacitor C, so that the waveform as shown in the small diagram (c) in FIG. 2A is generated between the power end 3 and the input end 4. Therefore, the instantaneous value detection method has high accuracy for waveforms amplified by filter capacitor C. So that, by comparing the second difference value between the first instantaneous value and the second instantaneous value with the second voltage threshold, it is possible to correctly determine whether the first relay RL1 is un-bridged (i.e., the relay RL does not bridge successfully).

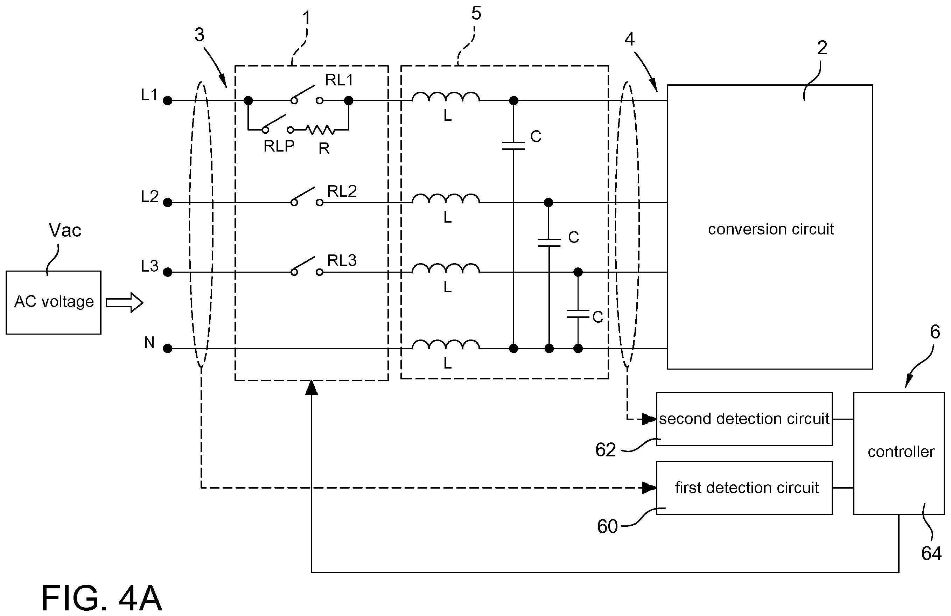

Please refer to FIG. 4A, which shows a circuit block diagram of a second embodiment of the AC/DC conversion circuit according to the present disclosure, and also refer to FIGs. 1 to 3B. The difference between FIG. 4A and FIG. 3A is that the conversion circuit 2 in FIG. 4A is a three-phase input circuit (three-phase four-wire input) and includes a first phase path L1, a second phase path L2, a third phase path L3, and a neutral path N. The switch circuit 1 includes a first relay RL1, a second relay RL2, a third relay RL3, and a pre-charge relay RLP, and the first relay RL1 is connected in series with the first phase path L1, and the first relay RL1, the second relay RL2, and the third relay RL3 are respectively connected in series with the first phase path L1, the second phase path L2, and the third phase path L3. Except for the above differences, the circuit structure of FIG. 4A is similar to that of FIG. 3A and will not be repeated herein.

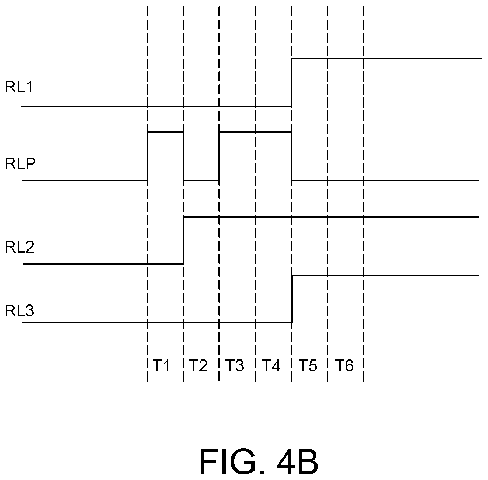

Please refer to FIG. 4B, which shows a relay control timing diagram of the second embodiment according to the present disclosure, and also refer to FIGs. 1 to 4A. In FIG. 4B mainly shows the timing of the relays (i.e., the first relay RL1, the second relay RL2, the third relay RL3, and the pre-charge relay RLP) of FIG. 4A when the conversion circuit 2 is intended to receive the AC voltage Vac to enable, and the detection circuits used in each time period T1 to T6 will be described sequentially. In FIG. 4B, the controller 64 sequentially controls the pre-charge relay RLP, the second relay RL2, the third relay RL3, and the first relay RL1 to turn on, and when the first relay RL1 and the third relay RL3 are turned on, the pre-charge relay RLP that is connected in parallel with the first relay RL1 is turned off to avoid the resistor R from continuously wasting power. In addition, the controller 64 can also confirm whether the first relay RL1 and the pre-charge relay RLP are actuating normally by controlling the pre-charge relay RLP to be turned off/on for testing (i.e., time period T2 to T3). Therefore, the controller 64 sets the pre-charge relay RLP as the initial relay (i.e., the first relay to be controlled for turning on), and sets the third relay RL3 and the first relay RL1 as the final relays (i.e., the last relay(s) to be controlled for turning on).

Before time period T1, the conversion circuit 2 is intended to receive the AC voltage Vac and be enabled. Therefore, during time period T1, controller 64 controls pre-charge relay RLP that is set as the initial relay to turn on. Furthermore, when controller 64 controls pre-charge relay RLP to turn on, controller 64 acquires the first RMS value on the second phase path L2 of power end 3 through the first voltage parameter, and acquires the second RMS value on the second phase path L2 of input end 4 through the second voltage parameter. In addition, the controller 64 also acquires the first RMS value on the third phase path L3 of the power end 3 through the first voltage parameter, and acquires the second RMS value on the third phase path L3 of the input end 4 through the second voltage parameter. Then, the controller 64 presets the first voltage threshold, and when the first difference value between the first RMS value and the second RMS value of the second phase path L2 is lower than the first voltage threshold, the controller 64 determines that the second relay RL2 is sticking and the sticking fault has occurred. Furthermore, when the first difference value between the first RMS value and the second RMS value on the third phase path L3 is lower than the first voltage threshold, the controller 64 determines that the third relay RL3 is sticking and the sticking fault has occurred.

Furthermore, when the controller 64 controls the pre-charge relay RLP to turn on, and regardless of whether the pre-charge relay RLP turns on normally, the conversion circuit 2 should not yet form a complete input loop. Therefore, the waveforms of the second phase path L2 and third phase path L3 between the power end 3 and the input end 4 should be as in small diagram (a) of FIG. 2C. However, if the pre-charge relay RLP is turned on normally and the second relay RL2 or the third relay RL3 is stuck and still in turn on state, the conversion circuit 2 may form the complete input loop. Therefore, the waveforms as shown in small diagram (b) of FIG. 2A are generated between the power end 3 and the input end 4. So that, using the RMS value detection method has higher accuracy. Therefore, by comparing the first difference value between the first RMS value and the second RMS value with the first voltage threshold, it is possible to correctly determine whether the second relay RL2 or the third relay RL3 is stuck.

At time period T2, the pre-charge relay RLP should be turned on normally, and controller 64 controls second relay RL2 to turn on. Furthermore, when the controller 64 controls the second relay RL2 to turn on, the controller 64 also controls the pre-charge relay RLP to turn off for testing, so as to confirm whether the first relay RL1 and the pre-charge relay RLP are actuated normally through the input loop that should not yet be formed completely. Then, when the controller 64 controls the second relay RL2 to turn on and the pre-charge relay RLP to turn off, the controller 64 acquires the first RMS value on the first phase path L1 of the power end 3 through the first voltage parameter, and acquires the second RMS value on the first phase path L1 of the input end 4 through the second voltage parameter. Then, when the first difference value between the first RMS value and the second RMS value is higher than the first voltage threshold, the controller 64 determines that the first relay RL1 or the pre-charge relay RLP is sticking and the sticking fault has occurred.

Furthermore, if no abnormality occurs in the timing of time period T1, the controller 64 may basically confirm that the second relay RL2 and the third relay RL3 are not stuck, but it is still uncertain whether they can be bridged normally. Therefore, when the controller 64 controls the second relay RL2 to turn on and the pre-charge relay RLP is turned off, the conversion circuit 2 should not yet form a complete input loop. Therefore, the waveform between the power end 3 and the input end 4 should be as shown in the small diagram (a) in FIG. 2C. However, if the first relay RL1 or the pre-charge relay RLP sticks and still in turn on state, the conversion circuit 2 may form the complete input loop. Therefore, the waveform as shown in small diagram (b) or (d) of FIG. 2A are generated between the power end 3 and the input end 4. So that, regardless of whether it is the small diagram (b) or (d) of FIG. 2A, using the RMS value detection method has higher accuracy. Therefore, by comparing the first difference value between the first RMS value and the second RMS value with the first voltage threshold, it is possible to correctly determine whether the first relay RL1 or the pre-charge relay RLP is stuck. In one embodiment, the difference in the waveform of the first relay RL1 or the pre-charge relay RLP being stuck depends on whether there is a phase difference, and the determination method is similar to FIG. 3B and will not be repeated herein.

At time period T3, the second relay RL2 should be turned on normally, and the controller 64 controls the pre-charge relay RLP to be turned on for testing, so as to confirm whether the second relay RL2 and the pre-charge relay RLP are actuated normally by forming a complete input loop. Then, when the controller 64 controls the pre-charge relay RLP to turn on, the controller 64 acquires the first RMS value on the first phase path L1 of the power end 3 through the first voltage parameter, and acquires the second RMS value on the first phase path L1 of the input end 4 through the second voltage parameter. Furthermore, the controller 64 also acquires the first RMS value on the second phase path L2 of the power end 3 through the first voltage parameter, and acquires the second RMS value on the second phase path L2 of the input end 4 through the second voltage parameter. Then, when the first difference value between the first RMS value and the second RMS value of the first phase path L1 is higher than the first voltage threshold, the controller 64 determines that the pre-charge relay RLP is un-bridged and the bridging fault has occurred. Furthermore, when the first difference value between the first RMS value and the second RMS value of the second phase path L2 is higher than the first voltage threshold, the controller 64 determines that the second relay RL2 is un-bridged and the bridging fault has occurred.

Furthermore, when the controller 64 controls the pre-charge relay RLP to turn on, and both the pre-charge relay RLP and the second relay RL2 must be turned on normally, the conversion circuit 2 will form a complete input loop. Therefore, the waveform of the first phase path L1 and the second phase path L2 between the power end 3 and the input end 4 should be as shown in the small diagram (b) in FIG. 2C, and there should be the phase difference between waveform A and waveform B. However, if one of the pre-charge relay RLP and the second relay RL2 cannot be bridged successfully, the conversion circuit 2 cannot form a complete input loop. Therefore, the waveform shown in the small diagram (a) in FIG. 2A is generated between the power end 3 and the input end 4. Under the present conditions, since the input loop should include an impedance loop, which involves the waveform with the phase difference, using the RMS value detection method has higher accuracy. In one embodiment, the controller 64 may selectively provide a time period T4 for temporarily delaying the next actuation, so as to provide the pre-charge loop through the time period T4 to charge the capacitor at the input end of the conversion circuit 2 to a specific value, thereby avoiding a condition that an excessive current flowing to the conversion circuit 2.

At the time period T5, the second relay RL2 and the pre-charge relay RLP should be turned on normally, and the controller 64 controls the first relay RL1 and the third relay RL3 that are set as the final relays to turn on. Furthermore, in the condition that the pre-charge relay RLP should be turned on normally, and when the first relay RL1 and the third relay RL3 are turned on, the controller 64 controls the pre-charge relay RLP to be turned off. Therefore, the main power path may be adjusted from the pre-charge loop to the main loop to avoid the resistor R continuously consuming power and causing the AC/DC conversion circuit 100 to be inefficient. In particular, although the controller 64 controls the first relay RL1 and the third relay RL3 to turn on together, the first relay RL1 and the third relay RL3 are respectively detecting at time periods T5 and time period T6.

Specifically, at the time period T5, the controller 64 controls the first relay RL1 and the third relay RL3 to be turn on. Then, the controller 64 is detecting the third relay RL3 at time period T5 and the first relay RL1 at time period T6. During the time period T5, the controller 64 may selectively use the RMS value or the instantaneous value detection and determination method. Specifically, the controller 64 may acquire the first RMS value at the power end 3 of the third relay RL3 through the first voltage parameter, and acquire the second RMS value at the input end 4 of the third relay RL3 through the second voltage parameter. Alternatively, the controller 64 may also acquire the first instantaneous value at the power end 3 of the third relay RL3 through the first voltage parameter, and acquire the second instantaneous value at the input end 4 of the third relay RL3 through the second voltage parameter. Furthermore, the controller 64 may select to make a determination using the first difference value between the first RMS value and the second RMS value and the first voltage threshold, and when the first difference value between the first RMS value and the second RMS value is higher than the first voltage threshold, the controller 64 determines that the third relay RL3 is un-bridged and the bridging fault has occurred. Similarly, the controller 64 may also select to make a determination using the second difference value between the first instantaneous value and the second instantaneous value and the second voltage threshold, and when the second difference value between the first instantaneous value and the second instantaneous value is higher than the second voltage threshold, the controller 64 may similarly determine that the third relay RL3 is un-bridged and the bridging fault has occurred.

Furthermore, when the controller 64 controls the third relay RL3 to turn on first and the pre-charge relay RLP is turned off, the conversion circuit 2 should still have the complete input loop, and no impedance loop is formed in the input loop. Therefore, the waveform between the power end 3 and the input end 4 should be as shown in the small diagram (d) in FIG. 2C. However, when the first relay RL1 cannot be bridged successfully, the input loop is disconnected and the filter capacitor C on the path of the relay that is turned on first still has no energy, so that a waveform as shown in the small diagram (a) in FIG. 2C is generated between the power end 3 and the input end 4. Therefore, under this condition, both the RMS value detection method and the instantaneous value detection method have high accuracy. So that, by using either the RMS value detection method or the instantaneous value detection method, it is possible to correctly determine whether the third relay RL3 is un-bridged (i.e., the relay RL does not bridge successfully).

At time period T6, the first relay RL1 should be turned on normally, and at time period T6, the controller 64 acquires the first instantaneous value on the first phase path L1 of the power end 3 through the first voltage parameter, and acquires the second instantaneous value on the first phase path L1 of the input end 4 through the second voltage parameter. Finally, the controller 64 presets the second voltage threshold, and when the second difference value between the first instantaneous value and the second instantaneous value is higher than the second voltage threshold, the controller 64 determines that the first relay RL1 is un-bridged and the bridging fault has occurred.

Furthermore, when the controller 64 controls the first relay RL1 to turn on, the conversion circuit 2 should still have a complete input loop, and no impedance loop is formed in the input loop. Therefore, the waveform of the first phase path L1 between the power end 3 and the input end 4 should be as shown in the small diagram (d) in FIG. 2C. However, if the first relay RL1 cannot be bridged successfully, there is energy on the filter capacitor C, so that the waveforms as shown in the small diagram (c) in FIG. 2C is generated at the first phase path L1 between the power end 3 and the input end 4. Therefore, the instantaneous value detection method has high accuracy for waveforms amplified by filter capacitor C. So that, by comparing the second difference value between the first instantaneous value and the second instantaneous value on the first phase path L1 with the second voltage threshold, it is possible to correctly determine whether the first relay RL1 is un-bridged (i.e., the relay RL does not bridge successfully).

Summarizing FIGs. 3A to 4B above, the main feature of the present disclosure is that, when the initial relay of the plurality of relays in the control switch circuit 1 is turned on, the detection and determination method is provided for determining whether at least one of the plurality of relays in the switch circuit 1 is turned on normally according to the first RMS value of the AC voltage Vac at the power end 3 and the second RMS value at the input end 4. Furthermore, when the first difference value between the first RMS value and the second RMS value is lower than the first voltage threshold, it may be determined that the sticking failure has occurred in switch circuit 1 (a certain relay). Then, when the final relay of the plurality of relays in the control switch circuit 1 is turned on, another detection and determination method is provided for determining whether at least one of the plurality of relays in the switch circuit 1 is turned on normally according to the first instantaneous value of the AC voltage Vac at the power end 3 and the second instantaneous value at the input end 4. Furthermore, when the second difference value between the first instantaneous value and the second instantaneous value is higher than the second voltage threshold, it can be determined that the final relay has the bridging fault. Therefore, the two detection methods shown in FIGs. 2A and 2B may be used in in the hybrid application, so as to reduce the probability of erroneous determination by using the other determination method when one of the two has a higher risk of the erroneous determination, so as to achieve the effect of improving the accuracy of the detection of the switch circuit.

## Claims

1. A detection method for detecting whether a plurality of relays (RL, RL1, RL2, RL3, RLP, RLN) of a switch circuit (1) are operate normally, wherein the switch circuit (1) is coupled between a power end (3) for receiving an AC voltage (Vac) and an input end (4) of a conversion circuit (2), such that the AC voltage (Vac) is supplied to the conversion circuit (2) through the switch circuit (1), the detection method comprising steps of:
sequentially controlling the relays (RL, RL1, RL2, RL3, RLP, RLN) to operate when the conversion circuit (2) is intended to receive the AC voltage (Vac),
determining whether at least one of the relays (RL, RL1, RL2, RL3, RLP, RLN) has been normally turned on according to a first RMS value of the AC voltage (Vac) at the power end (3) and a second RMS value at the input end (4) when controlling an initial relay of the relays (RL, RL1, RL2, RL3, RLP, RLN) to be turned on,
determining that a sticking fault has occurred in the switch circuit (1) when a first difference value between the first RMS value and the second RMS value is lower than a first voltage threshold,
determining whether a final relay has been normally turned on according to a first instantaneous value of the AC voltage (Vac) at the power end (3) and a second instantaneous value at the input end (4) when controlling the final relay of the relays (RL, RL1, RL2, RL3, RLP, RLN) to be turned on, and
determining that a bridging fault has occurred in the switch circuit (1) when a second difference value between the first instantaneous value and the second instantaneous value is higher than a second voltage threshold.

2. The detection method as claimed in claim 1, wherein the conversion circuit (2) is a single-phase input circuit comprising a first phase path (L1), a second phase path (L2), and a neutral path (N); the switch circuit (1) comprises a neutral line relay (RLN) connected in series with the neutral path (N), a first relay (RL1) connected in series with the first phase path (L1), and a pre-charge relay (RLP) connected in parallel with the first relay (RL1), and the detection method further comprising steps of:
setting the neutral line relay (RLN) to be the initial relay,
acquiring the first RMS value of the AC voltage on the first phase path (L1) at the power end (3) and the second RMS value of the AC voltage on the first phase path (L1) at the input end (4) when the neutral line relay (RLN) is controlled to be turned on, and
determining that the sticking fault has occurred due to the first relay (RL1) or the pre-charge relay (RLP) sticking when the first difference value between the first RMS value and the second RMS value is lower than the first voltage threshold.

3. The detection method as claimed in claim 2, further comprising steps of:
acquiring the first RMS value of the AC voltage on the first phase path (L1) at the power end (3) and the second RMS value of the AC voltage on the first phase path (L1) at the input end (4) when the neutral line relay (RLN) has been turned on and the pre-charge relay (RLP) is controlled to be turned on, and
determining that the bridging fault has occurred due to failure of the pre-charge relay (RLP) to bridge when the first difference value between the first RMS value and the second RMS value is higher than the first voltage threshold.

4. The detection method as claimed in claim 2, further comprising steps of:
setting the first relay (RL1) as the final relay,
controlling the pre-charge relay (RLP) to turn off when the pre-charge relay (RLP) has been turned on and the first relay (RL1) is controlled to be turned on,
acquiring the first instantaneous value of the AC voltage on the first phase path (L1) at the power end (3) and the second instantaneous value of the AC voltage on the first phase path (L1) at the input end (4), and
determining that the bridging fault has occurred due to failure of the first relay (RL1) to bridge when the second difference value between the first instantaneous value and the second instantaneous value is higher than the second voltage threshold.

5. The detection method as claimed in claim 1, wherein the conversion circuit (2) is a three-phase input circuit comprising a first phase path (L1), a second phase path (L2), and a third phase path (L3); the switch circuit (1) comprises a first relay (RL1) connected in series with the first phase path (L1), a pre-charge relay (RLP) connected in parallel with the first relay (RL1), a second relay (RL2) connected in series with the second phase path (L2), and a third relay (RL3) connected in series with the third phase path (L3), and the detection method further comprising steps of:
setting the pre-charge relay (RLP) as the initial relay,
acquiring the first RMS value of the AC voltage on the second phase path (L2) at the power end (3) and the second RMS value of the AC voltage on the second phase path (L2) at the input end (4), and acquiring the first RMS value of the AC voltage on the third phase path (L3) at the power end (3) and the second RMS value of the AC voltage on the third phase path (L3) at the input end (4) when the pre-charge relay (RLP) is controlled to be turned on,
determining that the sticking fault has occurred due to the second relay (RL2) sticking when the first difference value between the first RMS value and the second RMS value on the second phase path (L2) is lower than the first voltage threshold, and
determining that the sticking fault has occurred due to the third relay (RL3) sticking when the first difference value between the first RMS value and the second RMS value on the third phase path (L3) is lower than the first voltage threshold.

6. The detection method as claimed in claim 5, further comprising steps of:
controlling the pre-charge relay (RLP) to turn off when the pre-charge relay (RLP) has been turned on and the second relay (RL2) is controlled to be turned on,
acquiring the first RMS value of the AC voltage on the first phase path (L1) at the power end (3) and the second RMS value of the AC voltage on the first phase path (L1) at the input end (4), and
determining that the sticking fault has occurred due to the first relay (RL1) or the pre-charge relay (RLP) sticking when the first difference value between the first RMS value and the second RMS value is lower than the first voltage threshold.

7. The detection method as claimed in claim 5, further comprising steps of:
acquiring the first RMS value of the AC voltage on the first phase path (L1) at the power end (3) and the second RMS value of the AC voltage on the first phase path (L1) at the input end (4), and acquiring the first RMS value of the AC voltage on the second phase path (L2) at the power end (3) and the second RMS value of the AC voltage on the second phase path (L2) at the input end (4) when the second relay (RL2) has been turned on and the pre-charge relay (RLP) is controlled to be turned on,
determining that the bridging fault has occurred due to failure of the pre-charge relay (RLP) to bridge when the first difference value between the first RMS value and the second RMS value on the first phase path is higher than the first voltage threshold, and
determining that the bridging fault has occurred due to failure of the second relay (RL2) to bridge when the first difference value between the first RMS value and the second RMS value on the second phase path is higher than the first voltage threshold.

8. The detection method as claimed in claim 5, further comprising steps of:
setting the first relay (RL1) and the third relay (RL3) to be final relays (RL, RL1, RL2, RL3, RLP, RLN),
controlling the pre-charge relay (RLP) to turn off when the pre-charge relay (RLP) has been turned on and the first relay (RL1) and the third relay (RL3) are controlled to be turned on, and
first detecting an operating state of the third relay (RL3) and then detecting an operating state of the first relay (RL1) when the first relay (RL1) and the third relay (RL3) are controlled to be turned on.

9. The detection method as claimed in claim 8, further comprising steps of:
acquiring the first RMS value of the AC voltage on the third phase path (L3) at the power end (3) and the second RMS value of the AC voltage on the third phase path (L3) at the input end (4), and
determining that the bridging fault has occurred due to failure of the third relay (RL3) to bridge when the first difference value between the first RMS value and the second RMS value on the third phase path (L3) is lower than the first voltage threshold, or
acquiring a first instantaneous value of the AC voltage on the third phase path (L3) at the power end (3) and a second instantaneous value on the third phase path (L3) at the input end (4), and
determining that the bridging fault has occurred due to failure of the third relay (RL3) to bridge when the second difference value between the first instantaneous value and the second instantaneous value on the third phase path (L3) is higher than the second voltage threshold.

10. The detection method as claimed in claim 8, further comprising steps of:
acquiring a first instantaneous value of the AC voltage on the first phase path (L1) at the power end (3) and a second instantaneous value of the AC voltage on the first phase path (L1) at the input end (4),
determining that the bridging fault has occurred due to failure of the first relay (RL1) to bridge when the second difference value between the first instantaneous value and the second instantaneous value on the first phase path (L1) is higher than the second voltage threshold.

11. A detection circuit (6) for detecting whether a plurality of relays (RL, RL1, RL2, RL3, RLP, RLN) of a switch circuit (1) operate normally, wherein the switch circuit (1) is coupled between a power end (3) for receiving an AC voltage (Vac) and an input end (4) of a conversion circuit (2), such that the AC voltage (Vac) is supplied to the conversion circuit (2) through the switch circuit (1), the detection circuit (6) comprising:
a first detection circuit (60) coupled to the power end (3) and configured to detect the AC voltage (Vac) and provide a first voltage parameter,
a second detection circuit (62) coupled to the input end (4) and configured to detect the AC voltage (Vac) at the input end (4) and provide a second voltage parameter, and
a controller (64) coupled to the first detection circuit (60), the second detection circuit (62), and the relays (RL, RL1, RL2, RL3, RLP, RLN), wherein the relays (RL, RL1, RL2, RL3, RLP, RLN) are sequentially operated when the conversion circuit (2) is intended to receive the AC voltage (Vac),
wherein when an initial relay of the relays (RL, RL1, RL2, RL3, RLP, RLN) is turned on, the controller (64) is configured to determine whether a sticking fault has occurred in the switch circuit (1) according to a first RMS value of the first voltage parameter and a second RMS value of the second voltage parameter; when a final relay of the relays (RL, RL1, RL2, RL3, RLP, RLN) is turned on, the controller (64) is configured to determine whether a bridging fault has occurred in the switch circuit (1) according to a first instantaneous value of the first voltage parameter and a second instantaneous value of the second voltage parameter.

12. The detection circuit (6) as claimed in claim 11, wherein the conversion circuit (2) is a single-phase input circuit comprising a first phase path (L1), a second phase path (L2), and a neutral path (N), and wherein the switch circuit (1) comprises a neutral line relay (RLN) connected in series with the neutral path (N), a first relay (RL1) connected in series with the first phase path (L1), and a pre-charge relay (RLP) connected in parallel with the first relay (RL1); and
wherein the controller is configured to perform the steps as described in any one of claims 2 to 4 to determine whether a sticking fault or a bridging fault has occurred in the first relay (RL1), the neutral line relay (RLN), or the pre-charge relay (RLP).

13. The detection circuit (6) as claimed in claim 11, wherein the conversion circuit (2) is a three-phase input circuit comprising a first phase path (L1), a second phase path (L2), and a third phase path (L3), and wherein the switch circuit (1) comprises a first relay (RL1) connected in series with the first phase path (L1), a pre-charge relay (RLP) connected in parallel with the first relay (RL1), a second relay (RL2) connected in series with the second phase path (L2), and a third relay (RL3) connected in series with the third phase path (L3); and
wherein the controller is configured to perform the steps as described in any one of claims 5 to 10 to determine whether a sticking fault or a bridging fault has occurred in the first relay (RL1), the second relay (RL2), the third relay (RL3), or the pre-charge relay (RLP).
